Europäisches Patentamt

European Patent Office

Office européen des brevets

(11) Publication number: **0 456 060 B1**

# EUROPEAN PATENT SPECIFICATION

(45) Date of publication of patent specification: **13.09.95**    (51) Int. Cl.⁶: **C30B 33/06**

(21) Application number: **91106860.9**

(22) Date of filing: **26.04.91**

(54) **Process for bonding synthetic singel crystals.**

(30) Priority: **27.04.90 JP 112568/90**
         **26.12.90 JP 414582/90**

(43) Date of publication of application:
     **13.11.91 Bulletin 91/46**

(45) Publication of the grant of the patent:
     **13.09.95 Bulletin 95/37**

(84) Designated Contracting States:
     **DE FR GB**

(56) References cited:
     **EP-A- 0 355 340**
     **EP-A- 0 367 536**
     **EP-A- 0 416 301**
     **US-A- 3 116 175**

(73) Proprietor: **Aoshima, Hiroaki**
     **4-34-14 Yayoicho**
     **Nakano ku**
     **Tokyo (JP)**

(72) Inventor: **Aoshima, Hiroaki**
     **4-34-14 Yayoicho**
     **Nakano ku**
     **Tokyo (JP)**

(74) Representative: **Walter, Helmut, Dipl.-Ing.**
     **Aubinger Strasse 81**
     **D-81243 München (DE)**

## Description

### Field of the Invention

The present invention relates to a process for bonding synthetic single crystals, or more particularly concerns a process for bonding synthetic single crystals of a crystal system, and either or both of the cyrstals have anisotropic characteristics and can transmit light including visible light within a wavelength region, in a way that their assimilative faces are made to optically come in contact, and they are uniformly heated and gradually cooled or repeatedly heated and cooled gradually to produce an artificial lattice defect layer through a medium on their faces.

### Background of the Invention

A conventional process for directly or indirectly bonding or joining single crtystals has been done for isotropic single crtystals which are of an isometric or cubic system in which their physical properties are not different in terms of direction in the crtystal system. EP-A-0 355 340 relates to a process for producing structures for a scientific appliance, an ornamental article or the like by assembling and integrating a plurality of transparent synthetic single crystal pieces. In contrast, the present invention relates to a process for bonding two synthetic single crystals. EP-A-0 367 536 relates to a production of wafers for electronic devices In the production, a plurality of opaque semiconductive rod members are assembled in parallel with each other into an integrated body. In contrast, the present invention relates to a process for bonding two synthetic single crystals. Features of the present invention which are in congruence with the invention defined by the claims of EP-A-0 416 301 of same Applicant are written in the precharacterizing part of the independet claim of the following claims. The differences between the invention as claimed by the claimsof EP-A-0 416 301 on the one hand and of the present invention on the other hand are written in the second part of the said independent claim.

### Problems to be solved by the Invention

The main problem of the invention is to define a process which is capable of bonding two anisotropic single crystals, the physical properties of which are different in terms of the direction in the crystal system in a useful and efficient manner.

In view of the foregoing, an object of the present invention is to provide a process for bonding synthetic single crystals of a crystal system, and either or both of which have anisotropic characteristic and can transmit light within a wavelength region, thereby easily obtaining a new single crystal of complicated, precise shape having little chemical, physical and optical interference.

Briefly, the foregoing objects are accomplished in accordance with aspects of the present invention by a process for bonding synthetic single crystals according to the independent claim 1 of the following claims. Useful aspects of such a process are defined by the dependent claims.

When describing the invention in details phrases (1), (2), (3), and (4) will be used in the meaning described below.

(1) The phrase "... which are of a crystal system and either or both of which have anisotropic characteristic ... " means that in a crystal system, bonding is achieved for anisotropic single crystals whose physical properties are different in terms of direction or for an anisotropic single crystal and an isotropic single crystal which is not different in terms of the direction.

(2) The phrase "... can transmit lights including visible light within a wavelength region ..." means that the bonded interface surfaces can be easily observed directly by the naked eye or through a microscope during and after the process of bonding the single crystals together to inspect them.

(3) The phrase "... their assimilative faces are cut, optically come in polished, made to optically contact, and are uniformly heated and cooled gradually or repeatedly heated and gradually cooled to cause an interface reaction on the optically contacting faces (through a medium) ..." means the faces of the single crystals to be bonded together are physical covalent faces which are same axis faces for the same crystal system of the anisotropic crystals or assimilative faces for different crystal systems of the anisotropic and isotropic crystal. The faces are optically polished. Optical polishing destroys the regular configuration on the faces and gives a residual stress into a far depth. The resultant recrystallization causes denaturization, a distorted strain layer or formation of a twin on the face. The single crystals are bonded together to form optical contact of the faces which are optically polished in the way stated above, and is a theoretically destructive method of the crystal structure. The optical contact has been known as an amorphous and glass process in which the optically polished faces to be bonded together are cleaned and brought into contact by direct pressure without any artificial bonding agent. The whole unit, then, is uniformly heated and gradually cooled or repeatedly heated and gradually cooled to cause an interface reaction. In the course of bonding, the optically polished and bonded faces absorb oxygen and moisture thereon from the air. Such molecules can be easily dissociated from the faces to become oxygen and hydrogen atoms, which bond chemically with the atoms on the faces, or serve as the medium for bonding the faces.

(4) The phrase "a process for bonding synthetic single crystals ... to produce artificial lattice defect." means the crystal has atoms configured regularly therein in a three-dimensional framework of crystallographic axes. The angles subtended by the axes are referred to as the axial angles, and a ratio of the axis lengths is the axial ratio. The axial ratio of the isometric crystal is isotropic as $a = b = c$, and those of the other crystals are anisotropic as $a \neq b \neq c$ or $a = b \neq c$. The atoms and molecules are made to form a crystal like lattice regularly configured by a chemical bonding strength, such as an ionic bond, covalent bond, metallic bond, or van der Waals' bond. There are seven crystal systems having specific crystal structures.

The crystal structures are ideally configured in regular lattices, but contain some breaks and disturbance in them, which are called lattice defects. Lattice defects can be classified into face defect, linear defect, and point defect. Examples of face defects include the faces of the crystal, grain boundary, twinning plane, and stackings, the one of a linear defect is dislocation, and those of point defect are impurity atoms, atomic vacancy, and interstitial atoms. In addition, there are secondary defects, such as transition loops, which are changes of the primary defect due to some reactions after their generation. Lattice defects will not only affect the physical and chemical properties of the crystal to a great extent, but also exhibit their specific phenomena and actions (see the "Dictionary of Physics and Chemistry", 4th revision, Iwanami).

The present invention, as described above, concerns a process for bonding synthetic single crystals, wherein the crystal structure is intentionally changed under various artificial conditions and states, and either or both of the single crystals of a crystal system have anisotropic characteristic and can transmit light including visible light within a wavelength region. The crystals are bonded in a way that their assimilative faces are cut to have assimilative physical properties, optically polished, made to optically come in contact, and are uniformly heated and cooled gradually or repeatedly heated and gradually cooled to cause an interface reaction on the optically contacting faces through the medium to produce an artificial lattice defect.

The above and other objects, advantages and novel features of the invention will be more fully understood from the following detailed description and the accompanying drawings, in which like reference numbers indicate like or similar parts throughout wherein;

## Brief Description of the drawings

Fig. 1 is a photograph of a cross section of the optically polished interface of non-colored quartz single crystals bonded together in embodiment 1, which was shot with a scanning electron microscope (SEM). Fig. 2 are transmittance characteristic curves of a non-colored quartz single crystal plate and a pair of the plates bonded together measured in embodiment 1 with the use of a spectrophotometer.

Fig. 3 shows a quartz oscillator comprised of a pair of non-colored single crystal plates bonded together in an embodiment which oscillated at 4.11 MHz.

Fig. 4 is a photograph of a cross section of the optically polished interface of non-colored sapphire single crystals bonded together in embodiment 2, which was shot with a scanning electron microscope (SEM).

Fig. 5 are transmittance characteristic curves of a pair of the non-colored sapphire single crystal plates bonded together, the single crystal plate, a pair of the colored ruby single crystal plates, and the single crystal plate measured in embodiments with the use of a spectrophotometer.

## Detailed Description of the Invention

### Embodiment 1

The following describes an example of the process in which two non-colored quartz single crystals that are anisotropic and can all transmit light including visible light are bonded together. In the example, single crystals are identical in primary composition ($SiO_2$) and crystal system (hexagonal). Their light transmission ranges from 4000 to 7000 Angstroms at a transmittance of not more than 90 %. The single crystals are cut so that the faces to be bonded can be assimilated to each other in their physical properties such as the axes and axial angles, and their axial faces are optically polished to an accuracy of $\lambda/10$ where $\lambda$ is $63,28 \times 10^{-5}$ mm (6328 Angstroms). They are then bonded together, or made to optically come in contact, are heated uniformly and repeatedly to produce artificial lattice defects, and are cooled gradually for chemical bonding and stabilization.

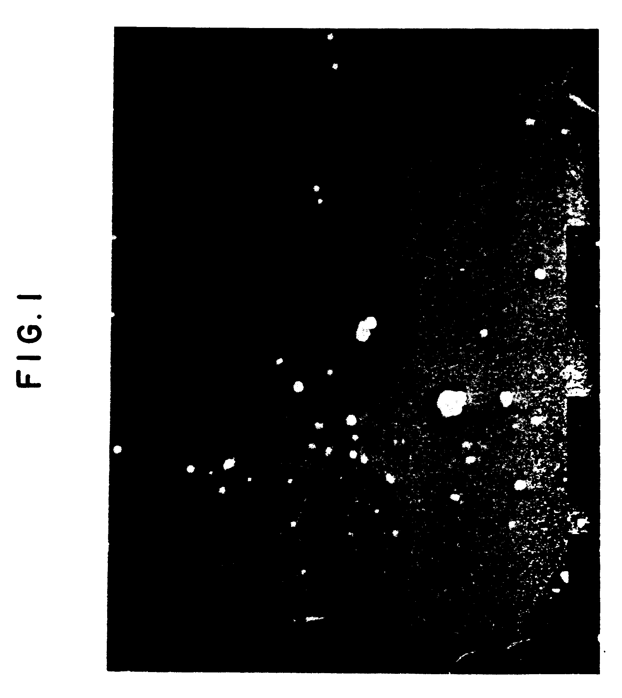

Fig. 1 is a photograph of a cross section of the optically polished interface of non-colored quartz single crystals bonded together in embodiment 1, which was shot with a scanning electron microscope (SEM). It can be estimated that the slight upper horizontal white band is the denatured layer, but it is not clearly determined what kind of lattice defect it belongs to.

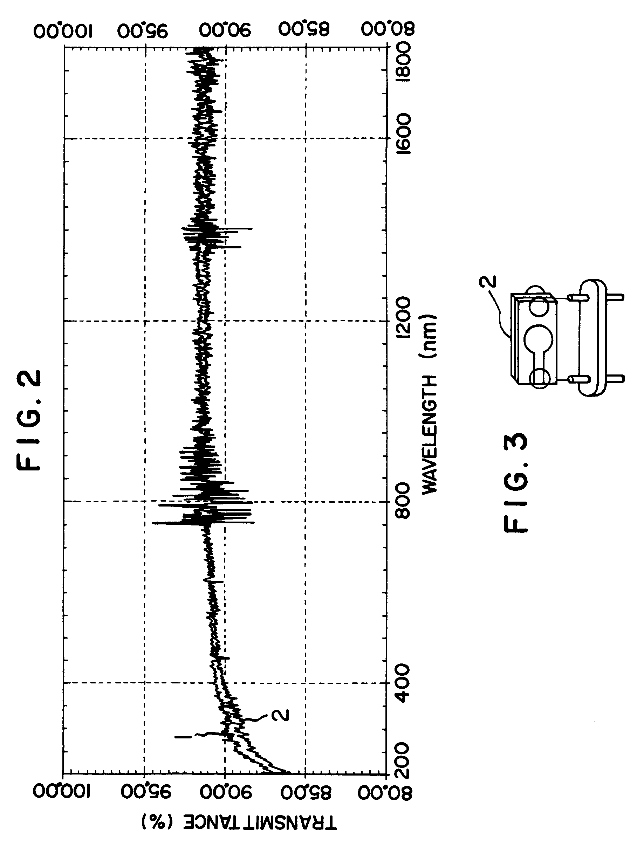

Fig. 2 are transmittance characteristic curves of a non-colored quartz single crystal plate 1 and a pair of the plates 2 bonded together measured in embodiment 1 with the use of a spectrophotometer.

Fig. 3 shows a quartz oscillator comprised of a pair of non-colored single crystal plates 2' bonded together in an embodiment, which oscillated at 4.11 MHz.

Embodiment 2

The following describes an example of the process in which two non-colored sapphire single crystals that are anisotropic and can all transmit lights including visible light are bonded together. In this example, single crystals are identical in the primary composition ($Al_2O_3$) and crystal system (hexagonal). Their light transmission ranges from 4 - 7 x $10^{-4}$ mm (4000 to 7000 Angstroms) at a transmittance of not more than 90 %. The single crystals are cut so that the faces to be bonded can be assimilated to each other in their physical properties such as the axes and axial angles, and their axial faces are optically polished to an accuracy of $\lambda/10$ where $\lambda$ is 63,28 x $10^{-5}$ mm (6328 Angstroms). They are then bonded together, or made to optically come in contact, are heated uniformly and repeatedly to produce artificial lattice defects, and are cooled gradually for chemical bonding and stabilization.

In a very similar way to the one mentioned above, it can have a colored ruby single crystal (containing impurities) bonded thereto, which is of an identical hexagonal system with $Al_2O_3$ - ($+Cr_2O_3$).

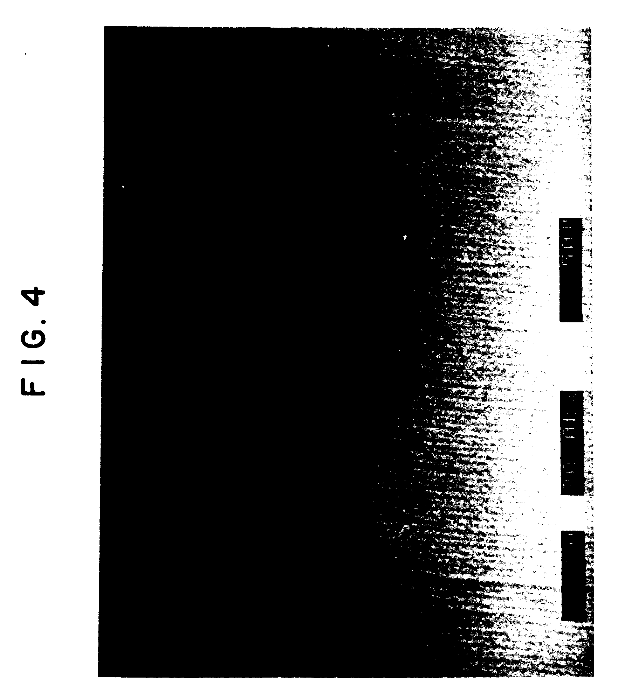

Fig. 4 is a photograph of a cross section of the optically polished interface of non-colored sapphire single crystals bonded together in embodiment 2, which was shot with a scanning electron microscope (SEM). It can be found that the slight lower horizontal line is the interface, and it is clearly observed that a series of knife edge-like vertical dislocations are caused by a deviation in the crystal.

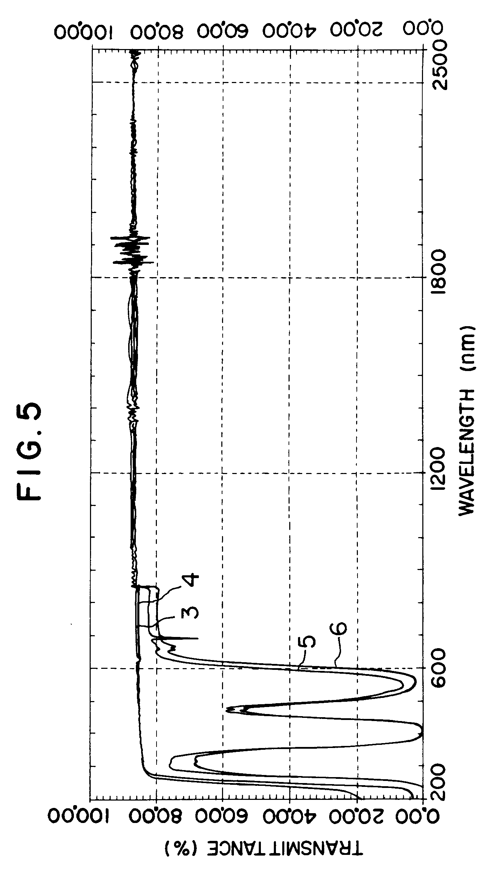

Fig. 5 are transmittance characteristic curves of pair 4 of non-colored sapphire single crystal plates 3 bonded together, single crystal plate 3, pair 6 of colored ruby single crystal plates 5, and single crystal plate 5 measured in embodiment 2 with the use of a spectrophotometer.

The reasons why quartz and sapphire single crystals were selected to bond are as follows. A quartz single crystal is interesting as a material in many respects. Its ideal chemical composition is

$SiO_2$, it is representative of silica minerals, its transparent crystal is called quartz, and the temperature quartz of the triagonal system can be changed quickly and reversely to a high temperature quartz of hexagonal system at 573 °C . It further can be transitioned to tridymite at 870 °C and to cristobalite at 1470 °C. As it is modified as such, it has been considered as unable to be processed by heat.

On the other hand, a sapphire single crystal has the ideal chemical composition of $Al_2O_3$, is very hard and fragile. The hardness of the same crystal varies to a great extent depending on the bearing of the lattice face. As for the axial characteristics of a sapphire single crystal, the ones in a direction parallel with the axis c are not identical with those in a direction perpendicular to it. Its coefficient of linear expansion is 0.67 x 10 $^{-5}$ per degree at 50 °C in a direction parallel with the axis c, and that is 0.50 x 10 $^{-5}$ per degree at 50 °C in a direction perpendicular to a axis c. As the physical properties of a sapphire single crystal are different depending on the axial direction as such, it may often have irregular cracks caused by possible contraction due to a anisotropy. It therefore has been considered as unable to be processed by heat as the quartz single crystal was.

The process according to the present invention is a process capable of bonding single crystals which previously has been impossible.

Within the scope of the present invention are possible a variety of combinations of crystal systems to bond, including a combination of a single crystals which are all anisotropic and can transmit visible light, for example, quartz single crystals and sapphire single crystals, and a combination of single crystals either of which are anisotropic and can transmit visible light, for example, sapphire single crystal and silicon crystal, which are very assimilative with other anisotropic crystals as its physical properties are independent from a direction as its primary component is Si and the crystal system is isometric. If the single crystals are far different in anisotropy and crystal system, an assimilated single crystal can be used as medium to bond them.Advantages

The process for bonding synthetic single crystals according to the present invention forms artificial lattice defects which allows bonding of a combination of single crystals to obtain a new single crystal body of complicated and precise shape, which has been impossible by the conventional process.

This invention is not to be limited by the embodiments shown in the drawings or described in the description but only in accordance with the scope of the appended claims.

## Claims

1. A process for bonding two synthetic single crystals by cutting faces of both synthetic single crystals to create assimilative physical properties, optically polishing said cut faces, contacting the cut faces with one another and uniformly heating and gradually cooling or repeatedly heating and gradually cooling the said faces **characterised in that** both synthetic single crystals are of the same crystal system and have different anisotropic physical properties in term of direction, or one of said synthetic single crystals is anisotropic and the other of said synthetic single crystals is isotropic where the isometric physical properties of said synthetic single crystals are not different in term of direction, after contacting the cut faces of said synthetic single crystals said faces are uniformly heated and gradually cooled or repeatedly heated and gradually cooled to produce artificial lattice defects at the contacting faces.

2. A process according to claim 1 including a assimilative single crystal medium between said synthetic single crystals to produce said artificial lattice defects.

3. A process according to claim 1 or 2 wherein said synthetic single crystals are selected from the group consisting of non-coloured quartz, non-coloured sapphire, ruby and silicon.

4. A Process according to claim 1 wherein said optically polished faces are polished to an accuracy of about λ/10 where λ is $63,28 \times 10^{-5}$ mm (6328 Å).

## Patentansprüche

1. Verfahren zum Verbinden zweier synthetischer Einkristalle miteinander, wobei das Verfahren folgende Verfahrensschritte einschließt: Bilden von Schnittflächen beider synthetischer Einkristalle zur Erzeugung aneinander angepaßter physicher Eigenschaften; optisches Polieren der Schnittflächen; Anlegen der Schnittflächen aneinander; gleichmäßiges Erhitzen und schrittweises Abkühlen oder wiederholtes Erhitzen und schrittweises Abkühlen der Flächen, **dadurch gekennzeichnet**, daß beide synthetischen Einkristalle dem gleichen Kristallsystem zugehören und verschiedene anisotropische physische Eigenschaften in der Termrichtung haben oder statt letzterem einer der synthetischen Einkristalle anisotropisch und der andere isotropisch ist, wobei die isometrischen physischen Eigenschaften der synthetischen Einkristalle nicht ungleich bezüglich der Termrichtung sind, daß nachdem die Schnittflächen der synthetischen Einkristalle diese Flächen gleichmäßig erhitzt und schrittweise abgekühlt oder wiederholt erhitzt und schrittweise abgekühlt werden, um künstliche Strukturfehler an den einander berührenden Schnittflächen zu erzeugen.

2. Verfahren nach Anspruch 1 mit einem angepaßten Einkristallmedium zwischen den synthetischen Einkristallen zur Erzeugung künstlicher Strukturfehler.

3. Verfahren nach Anspruch 1 oder 2, wobei die synthetischen Einkristalle aus einer Gruppe ausgewählt sind, die aus ungefärbtem Quarz, ungefärbtem Saphir, Rubin und Silizium gebildet wird.

4. Verfahren nach Anspruch 1, bei dem die optisch polierten Flächen auf eine Genauigkeit von etwa λ/10 poliert sind, worin λ = $63,28 \times 10^{5}$ mm (6328A) ist.

## Revendications

1. Processus pour lier deux monocristaux synthétiques en coupant des faces des deux monocristaux synthétiques pour créer des propriétés physiques assimilatives, en polissant, de façon optique, lesdites faces coupées, en mettant en contact les faces coupées l'une avec l'autre et en chauffant uniformément et en refroidissant progressivement, ou en chauffant de façon répétée et en refroidissant progressivement lesdites faces, **caractérisé en ce que** les deux monocristaux synthétiques sont du même système cristallin et ont des propriétés physiques anisotropes différentes en terme de direction, ou en ce qu'un desdits monocristaux synthétiques est anisotrope et l'autre desdits monocristaux synthétiques est isotrope lorsque les propriétés physiques isométriques desdits monocristaux synthétiques ne sont pas différentes en terme de direction, après avoir mis en contact les faces coupées desdits monocristaux synthétiques, lesdites faces sont uniformément chauffées et progressivement refroidies, ou sont chauffées de façon répétée et progressivement refroidies pour produire des défauts de réseau artificiels au niveau des faces en contact.

2. Processus selon la revendication 1 comprenant un milieu monocristallin assimilatif entre lesdits monocristaux synthétiques pour produire lesdits défauts de réseau artificiels.

3. Processus selon la revendication 1 ou 2, dans lequel lesdits monocristaux synthétiques sont sélectionnés à partir du groupe constitué du quartz incolore, du saphir incolore, du rubis et du silicium.

4. Processus selon la revendication 1, dans lequel lesdites faces polies de façon optique sont polies à une précision d'environ $\lambda/10$ où $\lambda$ est égal à $63,28 \times 10^{-5}$ mm (6328 Å).

FIG. I

# FIG. 2

FIG. 3

EP 0 456 060 B1

F I G. 4

# FIG.5

EP 0 456 060 B1